Europäisches Patentamt

European Patent Office

Office européen des brevets

(11) Publication number: **0 048 992**
**B1**

# (12) EUROPEAN PATENT SPECIFICATION

(45) Date of publication of patent specification: **07.12.88**

(21) Application number: **81107748.6**

(22) Date of filing: **29.09.81**

(51) Int. Cl.⁴: **H 05 K 1/05, H 05 K 3/44**

(54) Printed circuit board and method for fabricating the same.

(30) Priority: **30.09.80 JP 136570/80**
**25.10.80 JP 149909/80**

(43) Date of publication of application:
**07.04.82 Bulletin 82/14**

(45) Publication of the grant of the patent:
**07.12.88 Bulletin 88/49**

(84) Designated Contracting States:
**DE FR GB NL SE**

(56) References cited:
**GB-A- 990 023**
**JP-A-47 020 667**
**US-A-3 202 591**
**US-A-3 340 161**
**US-A-3 395 349**
**US-A-3 607 381**
**US-A-3 715 211**

(73) Proprietor: **KABUSHIKI KAISHA TOSHIBA**
**72, Horikawa-cho Saiwai-ku**
**Kawasaki-shi Kanagawa-ken 210 (JP)**

(72) Inventor: **Oodaira, Hiroshi**
**F 17-17 206-6, Tsutsumi**
**Chigasaki-shi Kanagawa-ken (JP)**
Inventor: **Nagashima, Kenji**
**1-4-6, Nakameguro**
**Meguro-ku Tokyo (JP)**
Inventor: **Matsumoto, Hiroshi**
**2-30-18, Tamagawa**
**Ota-ku Tokyo (JP)**
Inventor: **Tanaka, Masataka**
**1-2-29, Tatemachi**
**Kokurakitaku, Kitakyushu-shi (JP)**

(74) Representative: **Kador . Klunker . Schmitt-Nilson**
**. Hirsch**
**Corneliusstrasse 15**
**D-8000 München 5 (DE)**

Courier Press, Leamington Spa, England.

EP 0 048 992 B1

# EP 0 048 992 B1

## Description

The present invention relates to a printed circuit board and a method for fabricating the same, and particularly to a printed circuit board and a method for fabricating the same in which the printed circuit board has excellent heat-dissipating characteristics and dielectric strength.

Conventionally, an insulator (support) made of a resin and having a circuit pattern formed thereon is known as an electric printed circuit board. However, in this printed circuit board, the support has a large thermal resistance and a low heat-dissipating characteristic. Especially in hybrid integrated circuits in which semiconductor devices such as power transistors discharging a large amount of heat are formed on the support, a great amount of heat generated by the semiconductor devices must be dissipated from the circuit as soon as possible. For this purpose, an insulating support is conventionally adhered to a heat-dissipating plate with good heat conduction. However, the heat conduction speed depends on the thermal resistance of the insulating support. As a result, adhering a heat-dissipating plate to the insulating support does not improve heat dissipation. There are further drawbacks in that the mechanical strength of adhesion is weak and the heat resistance thereof is low.

Recently, a composite support in which an insulator is coated as a film on a metal plate having a good heat-dissipating characteristic has been developed. Supports of this type include an enamel substrate in which a glass layer is formed on an entire metal plate, and a substrate in which an insulating resin layer is coated on the major surface of a metal plate. A predetermined circuit pattern is formed on the enamel layer or the resin layer.

In the enamel substrate, sufficient heat resistance is achieved since the glass layer is coated on the surface of the metal plate. However, the glass layer has low heat conduction so that heat dissipation is not effectively performed. On the other hand, in the resin coated substrate, a conductive layer is formed on the insulating resin so that problems may occur due to characteristics such as heat resistance, thermal resistance, dielectric strength. For example, thermal resistance of the resin coated substrate is considered. The heat $Q$ conducted by a material is generally given by the following equation:

$$Q=(K \cdot A \cdot \Delta T)/\Delta X \tag{1}$$

where
$K$: heat conductivity of the material
$A$: cross section through which the heat is conducted
$\Delta X$: thickness of the material
$\Delta T$: temperature difference between the two ends of the material.
Equation (1) may be modified in the following relation:

$$\Delta T=[\Delta X/(K \cdot A)] \cdot Q \tag{2}$$

Relation (2) corresponds to Ohm's law in electronic circuits, that is, $V=R \cdot I$ (where V is the voltage, R, the resistance, and I, the current). $\Delta X/(K \cdot A)$ is defined as the thermal resistance and is represented by $R_{th}$. Therefore, the heat conductivity of the material depends on the $R_{th}$ value. For example, if the thickness $\Delta X$ of the material is small and the heat conductivity K is large, the thermal resistance $R_{th}$ becomes small, thus increasing the heat conduction. When the insulating resin layer is made of an epoxy resin to a thickness of 25 μm, the thermal resistance $R_{th}$ of this material is

$$(2.5 \times 10^{-3})/[(3.5 \times 10^{-3}) \cdot A]=0.71/A.$$

In this way, the thermal resistance becomes large. Thus, in the resin coated substrate, heat dissipation is not effectively performed.

GB—A—990 023 teaches a printed circuit board comprising a metal substrate, a ceramic insulating layer formed by flame spraying on the substrate, and an electrically conductive circuit pattern formed on the insulation layer. However, such a flame sprayed coating has an insufficient dielectric strength, particularly if placed in a humid atmosphere.

One object of the present invention is, therefore, to provide a printed circuit board having excellent heat resistance and heat-dissipating characteristics.

Another object of the present invention is to provide a printed circuit board in which dielectric strength is not degraded even if the printed circuit board is placed in a humid atmosphere.

For the above and other objects, the present invention provides a printed circuit board comprising a substrate with a good heat-dissipation and insulating layer made of ceramic material which is formed on the surface of said substrate and which has through pores; and a conductive circuit pattern layer directly formed on the surface of the insulating layer, wherein a resin with network structure fills and seals said through pores and is strongly bonded to said ceramic material by a silane coupling agent.

In the present invention, a ceramic layer which provides a good electrical insulation and good heat conduction is used as the insulating layer. Flame spray coating is used to form this ceramic film. With this flame spray coating, a ceramic layer with a number of fine through pores is formed. The resin with network

2

structure is filled in these through pores to seal them in order to improve the dielectric strength. The silane coupling agent is used to strongly couple the resin with the ceramic layer.

For forming this printed circuit board according to the present invention, after the ceramic layer is formed on the substrate, the through pores of the ceramic layer are treated with the silane coupling agent, the treated through pores are impregnated with an organic compound composition which may be converted to a resin with network structure by chemical reaction, and then the organic compound composition is converted to the resin with network structure. Alternatively, the silane coupling agent is added to the organic compound in advance and this compound may be filled in the through pores. Therefore, the organic compound is converted to the resin with network structure in the presence of the silane coupling agent. Finally, the desired circuit pattern is formed on the treated ceramic layer.

The printed circuit board according to the present invention utilizes the ceramic layer as the insulator which has excellent heat conductivity and electrical insulation, and the through pores of the ceramic layer are sealed by the resin with network structure having excellent heat resistance so that the printed circuit board has sufficient resistance to heat generated in the circuit pattern and the heat is quickly transferred to the heat-dissipating plate. Further, since the resin with network structures is strongly coupled, without a gap, with the ceramic layer in the through pores by means of the silane coupling agent, the dielectric strength of the printed circuit board is not degraded in a humid atmosphere.

This invention can be more fully understood from the following detailed description when taken in conjunction with the accompanying drawings, in which:

Fig. 1 is a sectional view of a printed circuit board in accordance with one embodiment of the present invention;

Figs. 2A to 2D are sectional views explaining the steps of a method for fabricating the printed circuit board shown in Fig. 1;

Fig. 3 is a sectional view explaining another embodiment according to the present invention; and

Fig. 4 is a sectional view of a circuit in which semiconductor elements are mounted on the printed circuit board of the present invention.

The present invention will be described in detail with reference to the accompanying drawings. In the figures, the same reference numerals denote the same parts.

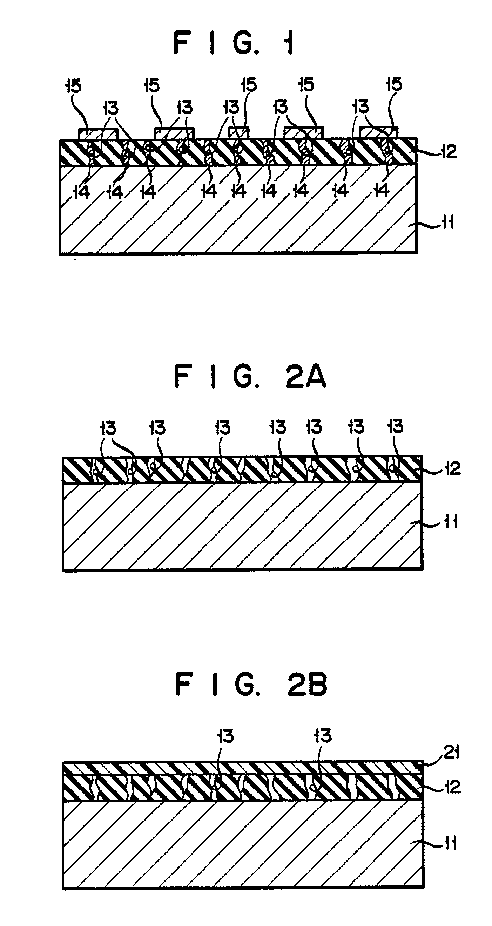

Referring to Fig. 1, the printed circuit board according to the present invention includes a substrate 11 formed of a metal having a good heat-dissipating characteristic, such as aluminum, copper, iron, nickel, silver, platinum, palladium, titanium, or zinc or an alloy thereof. The substrate 11 has a thickness of, for example, 0.5 mm to 3 mm. A ceramic layer 12 made of alumina, magnesia, beryllia, spinel, aluminum nitride, boron nitride, steatite ceramic, or a mixture of at least two of these materials is formed on the major surface of the substrate 11 to a thickness of, for example, 100 to 150 μm. As the ceramic layer 12 is formed by flame spray coating as will be described later, a number of through pores 13 are formed (the through pores in the figure are magnified). The microporous ceramic layer 12 formed by flame spray coating has 85 to 98% of the density of a ceramic sintered body, and the porosity is accordingly high.

The through pores 13 of the ceramic layer 12 are sealed by a heat-resistant resin 14 with network structure and the resin with network structure is strongly coupled with the ceramic layer 12 in the through pores 13 by a silane coupling agent.

A predetermined circuit pattern layer 15 is formed on the ceramic layer 12 to a thickness of, for example, 40 to 50 μm.

In order to form the printed circuit board the main surface of the heat dissipating substrate 11 is roughened. This roughening aims at increasing the adhesion between the substrate 11 and the ceramic layer 12 to be subsequently formed. The roughening is accomplished by spraying the substrate with a powder of relatively large particle size such as an alumina powder. The substrate 11 is roughened to have a surface roughness of 20 to 30 μm. Thereafter, as shown in Fig. 2A, the ceramic material is deposited on the substrate 11 to form the ceramic layer 12 having the through pores 13 preferably by a flame spray coating such as plasma arc spray coating before the roughened and exposed metal surface of the substrate 11 is oxidized and adhesion is degraded (usually within a time frame of one or two hours). In the plasma arc spray coating, an inert gas or a gas mixture of an inert gas and hydrogen is flowed between electrodes called plasma arc spray coating guns, an electric arc is generated to activate the gas, and then a heat plasma which is controlled to a temperature of 16,000°C is produced. Powdered ceramic of 10 to 50 μm size is introduced in the flame of the heat plasma and the melted ceramic is deposited on the substrate 11. The flame spray coating is thus carried out. Explosion spray coating may be utilized instead of plasma spray coating. The exposed surface of the ceramic layer 12 by such spray coating is rough with a three-dimensional configuration.

The resin 14 with network structure is formed in the through pores of the ceramic layer 12, which is coupled with the ceramic material by the silane coupling agent (refer to Fig. 2C). The "resin with network structure" is intended to mean a resin which has a three-dimensional network structure obtained by cross-linking of a polymer.

In order to prepare a resin with network structure, an organic compound which can form a resin with network structure by chemical reaction or curing is reacted and cured in the through pores in the presence of the silane coupling agent. Organic compounds which can be converted to a resin with network structure include a thermosetting resin such as an epoxy resin, a thermosetting acrylic resin, a thermosetting polyurethane resin, a diarylphthalate resin, a thermosetting polybutadiene resin, a thermosetting polyimide resin, a bismaleimide resin, and a mixture thereof; a combination of a hardening agent and one or more of these resins, a combination of a thermoplastic resin such as poly(1,2-butadiene)resin, polystyrene resin and methylmethacrylate resin and a multifunctional monomer (cross-linking agent); or a combination of a polymerizable monomer such as styrene, methyl methacrylate, divinylbenzene and glycidylmethacrylate and a polymerization initiating agent and a cross-linking agent. A thermosetting resin is irradiated or heated as needed in the presence of the hardening agent to prepare a resin with network structure. A thermoplastic resin is heated and cross-linked with a multifunctional monomer to prepare a resin with network structure. A polymerizable monomer is heated and polymerized in the presence of a catalyst and is cross-linked by the cross-linking agent to prepare a resin with network structure.

In the silane coupling agent, a hydrolyzable group included in the agent reacts with an inorganic material (ceramics), while an organic group such as a vinyl, alkyl, amino, methacryloxy, epoxy or mercapto group is bonded to the resin. Such a silane coupling agent includes vinyltrifluorosilane, vinyltriethoxy-silane, vinyltris($\beta$ - methoxyethoxy)silane, $\gamma$ - glycidoxypropyltrimethoxysilane, $\gamma$ - methacryloxy-propyltrimethoxysilane, N - $\beta$(aminoethyl) - $\gamma$ - aminopropyltrimethoxysilane, N - $\beta$(aminoethyl) - $\gamma$ - aminopropylmethyldimethoxysilane, $\gamma$ - chloropropyltrimethoxysilane, $\gamma$ - mercaptopropyltrimethoxy-silane, $\gamma$ - aminopropyltriethoxysilane, $\gamma$ - benzylaminopropyltrimethoxysilane, a mixture thereof and the like.

In a preferable method for preparing a resin with network structure, the through pores 13 of the ceramic layer 12 are treated with a silane coupling agent. The ceramic layer 12 is immersed in an aqueous solution of the silane coupling agent (for example, an aqueous solution of 0.1% to 10%) and is dried to deposit the silane coupling agent in the through pores 13. As shown in Fig. 2B, a desired organic compound 21 is coated on the ceramic layer 12 to impregnate the treated through pores. Alternatively, an organic compound to which the silane coupling agent is added (0.1% to 10%) is filled in the through pores 13 of the ceramic layer 12 in the same manner described above.

For impregnation, the viscosity of the composition is preferably 1 Pas (10 ps) or less (normally about 0,1 Pas (1 ps). When the organic compound is diluted with a solvent, the volume of the compound reduces when it is cured so that a small gap is formed between the through pores and the resin, thus degrading the insulating characteristic. Therefore, the viscosity of the compound must be controlled by heating.

After eliminating any excess compound remaining on the ceramic layer 12 by brushing, high pressure air spraying or the like, the compound and the ceramic material are strongly bonded by heating or light irradiation in accordance with the type of organic compound used. Then, the resin 14 with network structure which substantially completely seals the through pores 13 is obtained (Fig. 2C).

Thereafter, the cured resin still remaining on the ceramic layer 12 is eliminated in the same manner described above, exposing the rough surface of the ceramic layer 12. Thus, the obtained surface is preferable since the conductive layer to be formed thereover will be strongly adhered. As shown in Fig. 2D, a conductive layer 22 is formed on the ceramic layer 12 by electroless plating, and a predetermined pattern is formed by photoetching to obtain the circuit pattern layer 15 shown in Fig. 1. The material for electroless plating may be copper or nickel from consideration of economy, soldering characteristic, and safety. If an additive method is used in which an electroless plating layer is formed only on the desired surface portions for circuit pattern layer, the circuit pattern layer 15 is directly formed without using photoetching. If desired, electrical plating may be conducted in order to increase the layer thickness.

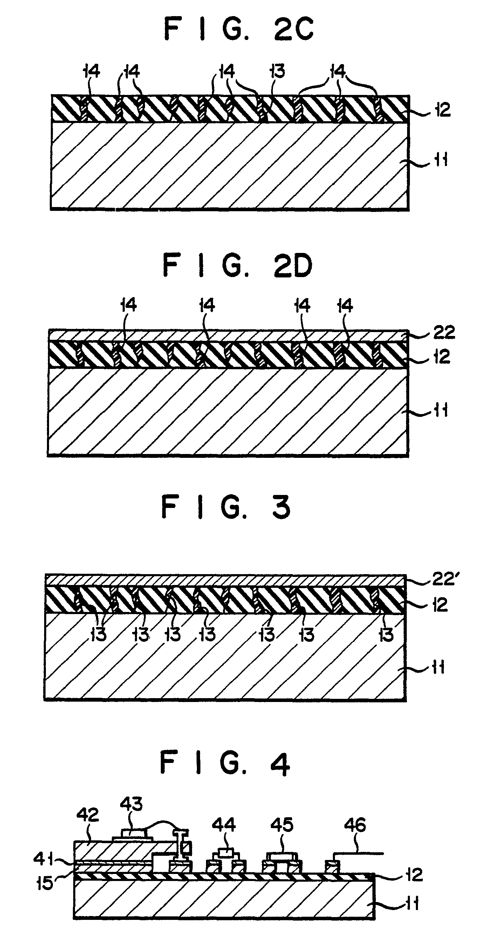

The conductive layer 22 may also be formed by flame spray coating as described above. In this case, as shown in Fig. 3, the ceramic layer 12 is formed on the substrate 11 and an organic compound is filled in the through pores 13 of the ceramic layer 12. Then, the compound is converted to the resin with network structure, and a conductive layer 22' is flame-sprayed on the ceramic layer 12. Finally, the conductive layer 22' is etched to obtain the circuit pattern.

On the circuit pattern layer described above, as shown in Fig. 4 for example, a solder paste 41 may be selectively printed, and a copper heat block 42 having a power transistor 43 placed thereon, a transistor 44 for a small signal, a resistor chip 45, and a terminal 46 can be placed thereon. Soldering is performed by preheating at 150°C for 15 seconds and then flowing the solder at 230°C for 15 seconds to mount each element. The circuit pattern layer with the elements can then be covered by a metal cover or the like to prepare a semiconductor device.

In summary, according to the present invention, the ceramic layer is used as the insulating layer which is formed on the substrate 11. The ceramic layer 12 has a higher heat conductivity than a glass layer or a resin layer (that is, the thermal resistance is smaller). When the ceramic layer is formed to a thickness of 100 μm, the thermal resistance of the ceramic layer which includes the epoxy resin sealing the through pores is obtained according to relation (2) described above:

$$100 \times 10^{-4}/0.26A = [3.85 \times 10^{-2}]/A.$$

Therefore, the thermal resistance is reduced to 1/18 the value for the conventional layer using the epoxy resin. As a result, when semiconductor elements are mounted on the printed circuit board with the structure described above, heat generated by the semiconductor elements is effectively dissipated outside.

Further, the ceramic layer is completely sealed by the resin with network structure strongly bonded to the ceramic material by means of the silane coupling agent, and moisture does not enter the through pores when the semiconductor device is placed in a humid atmosphere. This will be apparent from the example to be described below.

Example

Rough alumina powder was sprayed on a pure aluminum plate (metal substrate 11) having dimensions of 40 mm×60 mm×2 mm (thickness) to roughen the surface of the aluminum plate and to obtain a three-dimensional surface of 20 to 30 μm. By using a plasma arc spray coating machine, pure alumina of 98% purity or more was deposited on the aluminum plate 11 to a thickness of 100 to 120 μm. This substrate was immersed in a 3% aqueous solution of N - β(aminoethyl) - γ - aminopropyltriethoxysilane. The substrate was taken out of the solution and dried at 70°C for 30 minutes. The substrate was then heated to a temperature of 80°C and a bismaleide resin (trade name BT2103, manufactured by Mitsubishi Gas Chemical Co., Ltd.) was entirely coated thereover. After 3 minutes, the resin remaining on the surface was wiped off, and the resin was cured. Then a pattern having dimensions of 20 mm×20 mm was formed by printing a curing type silver paste thereon.

In the same manner, sample II was prepared without treatment by silane. Further, a thermosetting resin compound in which 3% of the silane coupling agent was added to a bismaleide resin without performing silane treatment was used to prepare sample III.

Samples I, II and III were placed in an atmosphere at 90% humidity and the dielectric strength of the samples were measured. The results are shown in the following table. The table shows that there were 20 of each sample. Specimens of each sample which showed a dielectric strength of more than DC 2 kV were regarded as specimens having good quality. The number of acceptable specimens are shown.

TABLE

|  | Initial number | After 96 hours | After 250 hours |
|---|---|---|---|
| Sample I | 20 | 20 | 20 |
| Sample II | 20 | 17 | 11 |
| Sample III | 20 | 20 | 19 |

In summary, according to the method of the present invention, a printed circuit board is provided which has an extremely small thermal resistance, thus providing compactness with high packaging density and preventing degradation of the dielectric strength even in a humid atmosphere.

**Claims**

1. A printed circuit board, comprising a substrate (11) with good heat dissipation; an insulating layer (12) made of a ceramic material which is formed on the surface of said substrate and which has through pores (13); and a conductive circuit pattern layer (15) directly formed on the surface of said insulating layer, characterized in that a resin with network structure (14) fills and seals said through pores (13), and is strongly bonded to said ceramic material by a silane coupling agent.

2. A printed circuit board according to claim 1, wherein said substrate is made of a metallic material.

3. A printed circuit board according to claim 2, wherein said insulating layer comprises a flame spray-coated ceramic layer.

4. A printed circuit board according to claim 3, wherein said ceramic material is selected from the group consisting of alumina, magnesia, beryllia, spinel, aluminum nitride, boron nitride, steatide ceramic and a mixture of at least two thereof.

5. A printed circuit board according to claim 1, wherein said silane coupling agent is selected from the group consisting of vinyltrifluorosilane, vinyltriethoxysilane, vinyltris(β - methoxyethoxy)silane, γ - glycidoxypropyltrimethoxysilane, γ - methacryloxypropyltrimethoxysilane, N - β(aminoethyl) - γ - aminopropyltrimethoxysilane, N - β(aminoethyl) - γ - aminopropylmethyldimethoxysilane, γ - chloropropyltrimethoxysilane, γ - mercaptopropyltrimethoxysilane, γ - aminopropyltriethoxysilane, γ - benzyl-aminopropyltrimethoxysilane, and mixtures thereof.

6. A printed circuit board according to claim 1, wherein said resin with network structure is derived from a thermosetting resin.

7. A printed circuit board according to claim 1, wherein said resin with network structure is derived from a combination of a thermoplastic resin and a multifunctional monomer.

8. A printed circuit board according to claim 1, wherein said resin with network structure is derived from a combination of a polymerizable monomer, a polymerization initiating agent and a cross-linking agent.

9. A printed circuit board according to claim 1, wherein said conductive circuit pattern layer is made of a metal layer coated by electroless plating.

10. A printed circuit board according to claim 1, wherein said conductive circuit pattern layer comprises a metal layer coated by spray coating.

11. A printed circuit board according to claim 1, further comprising semiconductor elements mounted on said conductive circuit pattern layer.

12. A method of fabricating a printed circuit board, comprising the steps of forming an insulating layer (12) having through pores (13) by flame spray coating a ceramic material (12) on the surface of a substrate (11) having good heat dissipation; and forming a conductive circuit pattern layer (15) directly on the surface of said insulating layer, characterized in that prior to forming said pattern layer (15) an organic compound composition to be converted by chemical reaction to a resin with network structure is introduced into the through pores (13) such that no resin is present on the surface of said insulating layer (12), and said organic compound composition is reacted in the presence of a silane coupling agent in said through pores (13) to provide the resin with network structure (14) which is strongly bonded to said ceramic material and seals said through pores (13).

13. A method according to claim 12, wherein said substrate is made of a metallic material.

14. A method according to claim 13, wherein said resin with network structure is formed by treating the through pores of said insulating layer with the silane coupling agent, impregnating the organic compound composition into said through pores and reacting said organic compound.

15. A method according to claim 13, wherein said resin with network structure is formed by filling a mixture of organic compound composition and the silane coupling agent in the through pores of said insulating layer, and reacting said mixture.

16. A method according to claim 14 or 15, wherein the organic compound composition comprises a thermosetting resin or a combination of a curing agent and a thermosetting resin.

17. A method according to claim 14 or 15, wherein the organic compound composition comprises a combination of a thermoplastic resin and a multifunctional monomer as a cross-linking agent.

18. A method according to claim 14 or 15, wherein the organic compound composition comprises a combination of a polymerizable monomer, a polymerization initiating agent and a cross-linking agent.

19. A method according to claim 12, wherein the organic compound composition is of the solvent-free type.

20. A method according to claim 12, wherein said conductive circuit pattern layer is formed by electroless plating.

21. A method according to claim 12, wherein said conductive circuit pattern layer is formed by flame spray coating a metal on said substrate.

22. A method according to claim 12, further comprising the step of mounting semiconductor elements on said conductive circuit pattern layer.

**Patentansprüche**

1. Platte für gedruckte Schaltungen, die ein Substrat (11) mit guter Wärmeabstrahlung, eine isolierende Schichte (12) aus Keramikmaterial, die auf der Oberfläche des Substrats gebildet ist und Durchgangsporen (13) aufweist, und eine leitfähige Schaltungsmusterschicht (15) aufweist, die direkt auf der Oberfläche der isolierenden Schicht gebildet ist, dadurch gekennzeichnet, daß ein harz mit Netzwerkstruktur (14) diese Durchgangsporen (13) füllt und abdichtet und durch ein Silankopplungsmittel fest an das Keramikmaterial gebunden ist.

2. Platte für gedruckte Schaltungen nach Anspruch 1, worin das Substrat aus Metallmaterial gefertigt ist.

3. Platte für gedruckte Schaltungen nach Anspruch 2, worin die isolierende Schicht eine thermisch gespritzte Keramikschicht umfaßt.

4. Platte für gedruckte Schaltungen nach Anspruch 3, worin das Keramikmaterial aus der Gruppe ausgewählt ist, die aus Aluminiumoxid, Magnesiumoxid, Berylliumoxid, Spinell, Aluminiumnitrid, Bornitrid, Steatidkeramik und einer Mischung von zumindest zwei davon besteht.

5. Platte für gedruckte Schaltungen nach Anspruch 1, worin das Silankopplungsmittel aus der Gruppe ausgewählt ist, die aus Vinyltrifluorsilan, Vinyltriethoxysilan, Vinyltris(β - methoxylethoxy)silan, γ - Glycidyoxypropyltrimethoxysilan, γ - Methacryloxypropyltrimethoxysilan, N - β(Aminoethyl) - γ - aminopropyltrimethoxysilan, N - β(Aminoethyl) - γ - aminopropylmethyldimethoxysilan, γ - Chlorpropyltrimethoxysilan, γ - Mercaptopropyltrimethoxysilan, γ - Aminopropyltriethoxysilan, γ - Benzylaminopropyltrimethoxysilan und Mischungen davon besteht.

6. Platte für gedruckte Schaltungen nach Anspruch 1, worin das Harz mit Netzwerkstruktur aus einem wärmehärtenden Harz abgeleitet wird.

7. Platte für gedruckte Schaltungen nach Anspruch 1, worin das Harz mit Netzwerkstruktur aus einer Kombination eines thermoplastischen Harzes und eines multifunktionalen Monomers abgeleitet ist.

8. Platte für gedruckte Schaltungen nach Anspruch 1, worin das Harz mit Netzwerkstruktur aus einer Kombination eines polymerisierbaren Monomers, eines die Polymerisation einleiteten Mittels und eines Vernetzungsmittels abgeleitet ist.

6

9. Platte für gedruckte Schaltungen nach Anspruch 1, worin die leitfähige Schaltungsmusterschicht aus einer Metallschicht gefertigt ist, die durch stromloses plattieren aufgebracht wurde.

10. Platte für gedruckte Schaltungen nach Anspruch 1, worin die leitfähige Schaltungsmusterschicht eine Metallschicht umfaßt, die durch Sprühbeschichtung aufgebracht wurde.

11. Platte für gedruckte Schaltungen nach Anspruch 1, die weiterhin Halbleiterelemente umfaßt, die auf der leitfähigen Schaltungsmusterschicht befestigt sind.

12. Verfahren zur Herstellung einer Platte für gedruckte Schaltungen, welches die Schritte der Bildung einer isolierenden Schicht (12) mit Durchgangsporen (13) durch thermisch gespritzte Beschichtung eines Keramikmaterials (12) auf der Oberfläche des Substrats (11) mit guter Wärmeabstrahlung und der Bildung einer leitfähigen Schaltungsmusterschicht (15) direkt auf der Oberfläche der isolierenden Schicht umfaßt, dadurch gekennzeichnet, daß vor der Bildung der Musterschicht (15) in die Durchgangsporen (13) eine Zusammensetzung einer organischen Verbindung eingeführt wird, die durch chemische Reaktion in ein Harz mit Netzwerkstruktur umgewandelt werden soll, so daß auf der Oberfläche der isolierenden Schicht (12) kein Harz vorhanden ist, und die Zusammensetzung der organischen Verbindung in Gegenwart eines Silankopplungsmittels in den Durchgangsporen (13) reagiert, um das Harz mit Netzwerkstruktur (14) zu liefern, das fest an das Cheramikmaterial gebunden ist und diese Durchgangsporen (13) abdichtet.

13. Verfahren nach Anspruch 12, worin das Substrat aus einem Metallmaterial gefertigt wird.

14. Verfahren nach Anspruch 13, worin das Harz mit Netzwerkstruktur gebildet wird, indem die Durchgangsporen der isolierenden Schicht mit dem Silankopplungsmittel behandelt werden, die Zusammensetzung der organischen Verbindung in die Durchgangsporen imprägniert wird und diese organische Verbindung reagiert.

15. Verfahren nach Anspruch 13, worin das Harz mit Netzwerkstruktur gebildet wird, indem eine Mischung einer Zusammensetzung der organischen Verbindung und des Silankopplungsmittels in die Durchgangsporen der isolierenden Schicht gefüllt wird und diese Mischung reagiert.

16. Verfahren nach Anspruch 14 oder 15, worin die Zusammensetzung der organischen Verbindung ein wärmehärtendes Harz oder eine Kombination eines Härters und eines wärmehärtenden Harzes umfaßt.

17. Verfahren nach Anspruch 14 oder 15, worin die Zusammensetzung der organischen Verbindung eine Kombination eines thermoplastischen Harzes und eines multifunktionalen Monomers als Vernetzungsmittel umfaßt.

18. Verfahren nach 14 oder 15, worin die Zusammensetzung der organischen Verbindung eine Kombination eines polisierbaren Monomers, eines die Polimerisation einleitenden Mittels und eines Vernetzungsmittels umfaßt.

19. Verfahren nach Anspruch 12, worin die Zusammensetzung der organischen Verbindung vom lösungsmittelfreien Typ ist.

20. Verfahren nach Anspruch 12, worin die leitfähige Schaltungsmusterschicht durch stromloses Plattieren gebildet wird.

21. Verfahren nach Anspruch 12, worin die leitfähige Schaltungsmusterschicht durch thermisch gespritzte Beschichtung eines Metalls auf dem Substrat gebildet wird.

22. Verfahren nach Anspruch 12, welches weiterhin den Schritt der Befestigung von Halbleiterelementen auf der leitfähigen Schaltungsmusterschicht umfaßt.

**Revendications**

1. Une plaquette de circuit imprimé comprenant un substrat (11) ayant une bonne dissipation thermique; une couche isolante (12) en un matériau céramique qui est formée sur la surface dudit substrat et qui a des pores traversants (13), et une couche conductrice de dessin de circuit (15) formée directement sur la surface de ladite couche isolante, caractérisée en ce qu'une résine à structure à réseau (14) remplit et scelle lesdits pores traversants (13) et est fortement liée audit matériau céramique par un agent de couplage du type silane.

2. Une plaquette de circuit imprimé selon la revendication 1, selon laquelle ledit substrat est un matériau métallique.

3. Une plaquette de circuit imprimé selon la revendication 2, selon laquelle ladite couche isolante comprend une couche céramique revêtue par pulvérisation à la flamme.

4. Une plaquette de circuit imprimé selon la revendication 3, selon laquelle ledit matériau céramique est choisi dans le groupe comprenant les suivants: alumine, magnésie, oxyde de béryllium, spinelle, nitrure d'aluminium, nitrure de bore, céramique stéatite et un mélange d'au moins deux de ceux-ci.

5. Une plaquette de circuit imprimé selon la revendication 1, selon laquelle ledit agent de couplage silane est choisi dans le groupe comprenant les suivants: vinyltrifluorosilane, vinyltriéthoxysilane, vinyltris(β - méthoxyéthoxy)silane, γ - glycidoxypropyltriméthoxysilane, γ - méthacryloxypropyltriméthoxysilane, N - β(aminoéthyl) - γ - aminopropyltriméthoxysilane, N - β(aminoéthyl) - γ - aminopropylméthyldiméthoxysilane, γ - chloropropyltriméthoxysilane, γ - mercaptopropyltriméthoxysilane, γ - aminopropyltriéthoxysilane, γ - benzylaminopropyltriméthoxysilane et leurs mélanges.

6. Une plaquette de circuit imprimé selon la revendication 1, selon laquelle ladite résine à structure à réseau est dérivée d'une résine thermodurcissable.

7. Une plaquette de circuit imprimé selon la revendication 1, selon laquelle ladite résine à structure à réseau est dérivée d'une combinaison d'une résine thermoplastique et d'un monomère multifonctionnel.

8. Une plaquette de circuit imprimé selon la revendication 1, selon laquelle ladite résine à structure à réseau est dérivée d'une combinaison d'un monomère polymérisable, d'un agent d'amorçage de polymérisation et d'un agent de réticulation.

9. Une plaquette de circuit imprimé selon la revendication 1, selon laquelle ladite couche conductrice de dessin de circuit est une couche métallique revêtue par plaquage non électrolytique.

10. Une plaquette de circuit imprimé selon la revendication 1, selon laquelle ladite couche conductrice de dessin de circuit comprend une couche métallique revêtue par revêtement par pulvérisation.

11. Une plaquette de circuit imprimé selon la revendication 1, comprenant en outre des éléments semi-conducteurs montés sur ladite couche conductrice de dessin de circuit.

12. Un procédé de fabrication d'une plaquette de circuit imprimé comprenant les étapes de formation d'une couche isolante (12) ayant des pores traversants (13) par revêtement par pulvérisation à la flamme d'un matériau céramique (12) sur la surface d'un substrat (11) ayant une bonne dissipation thermique; et de formation d'une couche conductrice de dessin de circuit (15) directement sur la surface de ladite couche isolante, caractérisé en ce qu'avant la formation de cette couche de dessin (15) une composition de composé organique à convertir par réaction chimique en une résine à structure à réseau est introduite dans les pores traversants (13) de façon telle qu'aucune résine n'est présente sur la surface de ladite couche isolante (12) et que ladite composition de composé organique est mise à réagir en présence d'un agent de couplage silane dans lesdits pores traversants (13) pour former la résine à structure à réseau (14) qui est fortement liée audit matériau céramique et qui scelle lesdits pores traversants (13).

13. Un procédé selon la revendication 12, selon lequel ledit substrat est fait d'un matériau métallique.

14. Un procédé selon la revendication 13, selon lequel ladite résine à structure à réseau est formée par traitement des pores traversants de ladite couche isolante par l'agent de couplage silane, imprégnation par la composition de composé organique dans lesdits pores traversants et réaction dudit composé organique.

15. Un procédé selon la revendication 13, selon lequel ladite résine à structure à réseau est formée par introduction d'un mélange de composition de composé organique et de l'agent de couplage silane dans les pores traversants de ladite couche isolante et réaction dudit mélange.

16. Un procédé selon la revendication 14 ou 15, selon lequel la composition de composé organique comprend une résine thermodurcissable ou une combinaison d'un agent de durcissement et d'une résine thermodurcissable.

17. Un procédé selon la revendication 14 ou 15, selon lequel la composition de composé organique comprend une combinaison d'une résine thermoplastique et d'un monomère multifonctionnel comme agent de réticulation.

18. Un procédé selon la revendication 14 ou 15, selon lequel la composition de composé organique comprend une combinaison d'un monomère polymérisable, d'un agent d'amorçage de polymérisation et d'un agent de réticulation.

19. Un procédé selon la revendication 12, selon lequel la composition de composé organique est du type exempt de solvant.

20. Un procédé selon la revendication 12, selon lequel ladite couche conductrice de dessin de circuit est formée par plaquage non électrolytique.

21. Un procédé selon la revendication 12, selon lequel ladite couche conductrice de dessin de circuit est formée par revêtement par pulvérisation à la flamme d'un métal sur ledit substrat.

22. Un procédé selon la revendication 12, comprenant en outre l'étape de montage des éléments semi-conducteurs sur ladite couche conductrice de dessin de circuit.

EP 0 048 992 B1

# F I G. 1

# F I G. 2A

# F I G. 2B

1

# F I G. 2C

# F I G. 2D

# F I G. 3

# F I G. 4